(19) **Europäisches Patentamt**

**European Patent Office**

**Office européen des brevets**

(11) **EP 1 443 127 B1**

(12) **EUROPEAN PATENT SPECIFICATION**

(45) Date of publication and mention
of the grant of the patent:
**17.08.2005 Bulletin 2005/33**

(51) Int Cl.⁷: **C23C 14/24**, C23C 16/448,
C23C 14/12

(21) Application number: **04075121.6**

(22) Date of filing: **16.01.2004**

(54) **Method for coating large-area substrates**

Verfahren zum Beschichten von grossflächigen Substraten

Procédé pour rêveter de substrats de la surface grande

(84) Designated Contracting States:
**DE FR GB**

(30) Priority: **28.01.2003 US 352558**

(43) Date of publication of application:
**04.08.2004 Bulletin 2004/32**

(73) Proprietor: **EASTMAN KODAK COMPANY**
**Rochester, New York 14650 (US)**

(72) Inventors:
- **Grace, Jeremy M., c/o Eastman Kodak Company**
 **Rochester New York 14650-2201 (US)**
- **Freeman, Dennis R.,**
 **c/o Eastman Kodak Company**
 **Rochester New York 14650-2201 (US)**

- **Redden, Neil, c/o Eastman Kodak Company**
 **Rochester New York 14650-2201 (US)**
- **Van, Steven A. c/o Eastman Kodak Company**
 **Rochester New York 14650-2201 (US)**
- **Klug, Justin H., c/o Eastman Kodak Company**
 **Rochester New York 14650-2201 (US)**

(74) Representative: **Haile, Helen Cynthia et al**
**Kodak Limited,**
**Patent Department (W92-3A),**
**Headstone Drive**
**Harrow, Middlesex HA1 4TY (GB)**

(56) References cited:
**EP-A- 1 342 808          EP-A- 1 382 713**
**US-A1- 2001 005 553      US-B1- 6 237 529**

## EP 1 443 127 B1

**Description**

The present invention relates generally to vapor deposition of an organic layer onto a structure which will form part of an organic light-emitting device (OLED). More generally it relates to coating layers used in producing luminescent devices, whether electroluminescent, photoluminescent, luminescent by action of ionizing radiation, or otherwise luminescent, as well as devices made with photoconducting materials.

An organic light-emitting device, also referred to as an organic electroluminescent device, can be constructed by sandwiching two or more organic layers between first and second electrodes.

In a passive matrix organic light-emitting device (OLED) of conventional construction, a plurality of laterally spaced light-transmissive anodes, for example indium-tin-oxide (ITO) anodes, are formed as first electrodes on a light-transmissive substrate such as, for example, a glass substrate. Two or more organic layers are then formed successively by vapor deposition of respective organic materials from respective sources, within a chamber held at reduced pressure, typically less than $10^{-3}$ torr ($1.33 \times 10^{-1}$ pascal). In addition to doped or undoped organic light-emitting material, typical organic layers used in making OLEDS are doped or undoped organic hole-injecting material, doped or undoped organic hole-transporting material, and doped or undoped organic electron-transporting material, where doping refers to adding a minor constituent to enhance the electrical performance, optical performance, stability, or life time of a given material or device constructed thereof. A plurality of laterally spaced cathodes is deposited as second electrodes over an uppermost one of the organic layers. The cathodes are oriented at an angle, typically at a right angle, with respect to the anodes.

Applying an electrical potential (also referred to as a drive voltage) operates such conventional passive matrix organic light-emitting devices between appropriate columns (anodes) and, sequentially, each row (cathode). When a cathode is biased negatively with respect to an anode, light is emitted from a pixel defined by an overlap area of the cathode and the anode, and emitted light reaches an observer through the anode and the substrate.

In an active matrix organic light-emitting device (OLED), an array of anodes is provided as first electrodes by thin-film transistors (TFTs) which are connected to a respective light-transmissive portion. Two or more organic layers are formed successively by vapor deposition in a manner substantially equivalent to the construction of the aforementioned passive matrix device. A common cathode is deposited as a second electrode over an uppermost one of the organic layers. The construction and function of an active matrix organic light-emitting device is described in U.S. Patent 5,550,066.

Organic materials, thicknesses of vapor-deposited organic layers, and layer configurations, useful in constructing an organic light-emitting device, are described, for example, in U.S. Patents 4,356,429, 4,539,507, 4,720,432, and 4,769,292.

Other kinds of imaging devices, such as imaging phosphors for computed radiography and x-ray photoconductive devices for digital radiography, depend on the ability to coat the active materials uniformly over large areas. While the discussion below pertains to organic light-emitting devices, it should be readily apparent that the same invention can be applied to the deposition of alkalihalide phosphors, amorphous semiconductors, and other luminescent or photoactive layers, as well as a variety of other materials used in devices based on such luminescent or photoactive layers.

For sufficiently small substrates, a point source approach can be implemented wherein the material to be deposited emanates from a localized heated crucible and the substrate is placed sufficiently far from the localized region of vaporization that the coating is sufficiently uniform along the substrate. As substrate size increases or working distance decreases, rotary or planetary motion of the substrate relative to the localized source is often required to produce the desired uniformity.

By elongating the vaporization source and providing for translation of source and substrate relative to one another, the desired uniformity can be attained at considerably smaller working distances and thus considerably higher rates and better materials utilization, if desired. Scaling of such a process to large areas (i.e. substrates greater than 15 cm in at least one dimension) is considerably easier than for point sources.

An elongated source for thermal physical vapor deposition of organic layers onto a structure for making an organic light-emitting device has been disclosed by Robert G. Spahn in commonly assigned U.S. Patent 6,237,529, issued May 29, 2001. The source disclosed by Spahn includes a housing, which defines an enclosure for receiving solid organic material, which can be vaporized. The housing is further defined by a top plate which defines a vapor efflux slit-aperture for permitting vaporized organic materials to pass through the slit onto a surface of a structure. The housing defining the enclosure is connected to the top plate. The source disclosed by Spahn further includes a conductive baffle member attached to the top plate. This baffle member provides line-of-sight covering of the slit in the top plate so that vaporized organic material can pass around the baffle member and through the slit onto the substrate or structure while particles of organic materials are prevented from passing through the slit by the baffle member when an electrical potential is applied to the housing to cause heat to be applied to the solid organic material in the enclosure causing the solid organic material to vaporize.

In using the thermal physical vapor deposition source disclosed by Spahn to form an organic layer of a selected organic material on a substrate or structure, it has been found that the vapor efflux slit-aperture causes nonuniform vapor flux of organic material vapor to emanate along a length dimension of the slit. While the technical or physical aspects of source design related to this nonuniformity of vapor flux are not fully understood at present, it appears that opposing edges of the slit-aperture, i.e. edges opposed in a width direction of the slit, sag or rise nonuniformly over a central portion of the slit when the source is heated to cause vaporization of solid organic material. This is a particular problem when a width dimension of the slit is reduced, for example, to a width dimension less than 0.5 millimeter (mm). Such spatially nonuniform orientation of opposing slit edges can be thought of as a deviation of planarity of opposing edges which, in turn, can promote a greater fraction of vaporized organic material to exit the vapor deposition source through a central portion of the slit, with a correspondingly lower fraction of vaporized organic material exiting the source through remaining portions of the slit along its length dimension. Such nonuniform vapor flux, directed at a substrate or structure, will cause the formation of an organic layer thereon which will have a nonuniform layer thickness in correspondence with the nonuniform vapor flux.

In addition, any nonuniformities in heat generation from the heater or heat absorption by the material to be deposited or distribution of said material within the source can give rise to nonuniformity in deposition along the length of the source. Yet another potential source of nonuniformity is unintended leaks in the source enclosure other than the apertures used to deliver the material vapor. If such leaks exist at the ends of the source, the flow of vapor from center to end of the source can cause pressure gradients within the source, thereby causing nonuniformity in the resultant deposition.

Forrest et al. (US 6,337,102 B1) disclose a method for vaporizing organic materials and organic precursors and delivering them to a reactor vessel wherein the substrate is situated and delivery of the vapors generated from solids or liquids is accomplished by use of carrier gases. In one embodiment of their invention, Forrest et al. locate the substrates within a suitably large reactor vessel, and the vapors carried thereto mix and react or condense on the substrate. Another embodiment of their invention is directed towards applications involving coating of large area substrates and putting several such deposition processes in serial fashion with one another. For this embodiment, Forrest et al. disclose the use of a gas curtain fed by a gas manifold (defined in the disclosure as "hollow tubes having a line of holes") in order to form a continuous line of depositing material perpendicular to the direction of substrate travel.

The approach to vapor delivery as disclosed by Forrest et al. can be characterized as "remote vaporization" wherein a material is converted to vapor in an apparatus external to the deposition zone and more likely external to the deposition chamber. Organic vapors, alone or in combination with carrier gases are conveyed into the deposition chamber and ultimately to the substrate surface. Great care must be taken using this approach to avoid unwanted condensation in the delivery lines by use of appropriate heating methods. This problem becomes even more critical when contemplating the use of inorganic materials that vaporize to the desired extent at substantially higher temperatures. Furthermore, the delivery of the vaporized material for coating large areas uniformly requires the use of gas manifolds. No mention of the requirements for such a gas manifold is made by Forrest et al.

As can be appreciated from the disclosure of Forrest et al., one skilled in the art would expect to have difficulty providing uniform films from an elongated source in which the material is vaporized along the length of a deposition source within the deposition zone. There is a need therefore for an improved method of designing a thermal physical vapor deposition system in which the material is vaporized along the length of a deposition source within the deposition zone that avoids the problems noted above.

The need is met according to the present invention by providing a method of designing a system for thermal vapor deposition that includes a material to be deposited on a workpiece, an elongated container for containing the material, a heater for heating the material in the container to vaporize the material, the container defining n apertures for emitting the vaporized material in an elongated pattern in the elongated direction, that includes the steps of: calculating the total source throughput Q per unit length at a deposition rate of interest; calculating the internal pressure P of the source required to produce Q for the total aperture conductance $C_A$ of the source; modeling the system as a ladder network of conductances, the elongated container having a container conductance $C_B$ and conductances $C_b = nC_B$, between apertures, and the apertures having a combined conductance

$$C_A = \sum_{i=1}^{n} C_{ai} \, ,$$

where $C_{ai}$ are individual aperture conductances; and using the ladder network model, designing the system to have a desired pressure uniformity along the elongated direction of the container.

A novel system and method resulting from the design method includes a material to be deposited on a workpiece; an elongated container for containing the material, the container having a conductance $C_B$ in the elongated direction; a heater for heating the material in the container to vaporize the material to a partial pressure Pm; the container defining one or more apertures for emitting the vaporized material in an elongated pattern in the elongated direction, the one or more apertures having a conductance $C_A$; and wherein $\dfrac{C_A}{C_B} \leq 0.5$.

### ADVANTAGES

The present invention demonstrates an unanticipated way in which the design of the gas manifold depends on the operating pressure and provides a means to overcome the problems one skilled in the art would reasonably expect to encounter. An advantage of the present invention is that the design based on the conductance ratio ensures tolerance to nonuniformities in vaporization of material in the container, these nonuniformities arising from a variety of sources, including, non-uniform heating of the heater, nonuniform distribution of the material in the container, and non-uniform application of radiant heat from the heater surface to the surface of the material in the container.

Another advantage of the present invention is that the conductance criterion (i.e. $C_A/C_B$ < a specified value) ensures tolerance to significant vapor flow along the length of the source. Such vapor flow can arise from condensation of material at the ends of the source or unintentional leaks at either or both ends of the source.

Another advantage of the present invention is that the vapor deposition source can be made to operate over a wide range of deposition rate from the desired minimum deposition rate for the material to be deposited to substantially higher rates, or a suitably inert gas may be used to provide internal pressure sufficient to maintain adequate gas conductance along the vapor deposition source length and to allow operation from the highest intended deposition rates down to arbitrarily low rates.

FIG. 1 is a schematic view of an elongated vapor deposition source having a rectangular cross section that can be designed according to the present invention.

FIG. 2 is a schematic view of an elongated vapor deposition source having a circular cross section that can be designed according to the present invention.

FIG. 3 is a schematic representation of the conductances governing the emission of material from the vapor deposition source.

FIG. 4 is a circuit model of the worst-case scenario for deposition using a source as described in FIGs. 1, 2 and 3.

FIG. 5 is a schematic cross sectional view of an elongated vapor deposition source being used to coat a large substrate.

FIG. 6 is a schematic sectional view of a vapor deposition station dedicated to forming vapor-deposited layers and showing a structure being moved by a lead screw with respect to a stationary vapor deposition source to provide a uniformly vapor-deposited layer over the substrate, in accordance with an aspect of the present invention.

FIG. 7 is a graph of vapor pressure as a function of 1/Temperature for A1Q, as measured by thermal gravimetric analysis.

FIG. 8 is a graph of the pressure nonuniformity along the source length as a function of deposition rate for examples 1 - 5.

FIG. 9 is a graph of the pressure nonuniformity inferred from observed rate nonuniformity as a function of the experimental deposition rate at an aperture-substrate spacing of 10 cm and for two different degrees of internal mass flow arising from condensation at the ends of the source.

FIG. 10 is a graph of the calculated pressure drop along the source length as a function of cross sectional area of the source for examples 1 - 5.

FIG. 11 is a graph of the calculated pressure nonuniformity along the source length as a function of the conductance ratio for examples 1 - 5. Data are shown for no leak at the far end and a leak equal to the total aperture conductance.

FIG. 12 is a flow chart for the calculation of conductances and pressure distribution in the deposition source.

The present invention provides a method of designing a vapor deposition system that includes a heated container in which a material is vaporized (whether it be a heated crucible, a heated bubbler, or some other form of heated container) and a gas delivery manifold defined by one or more apertures in the container.

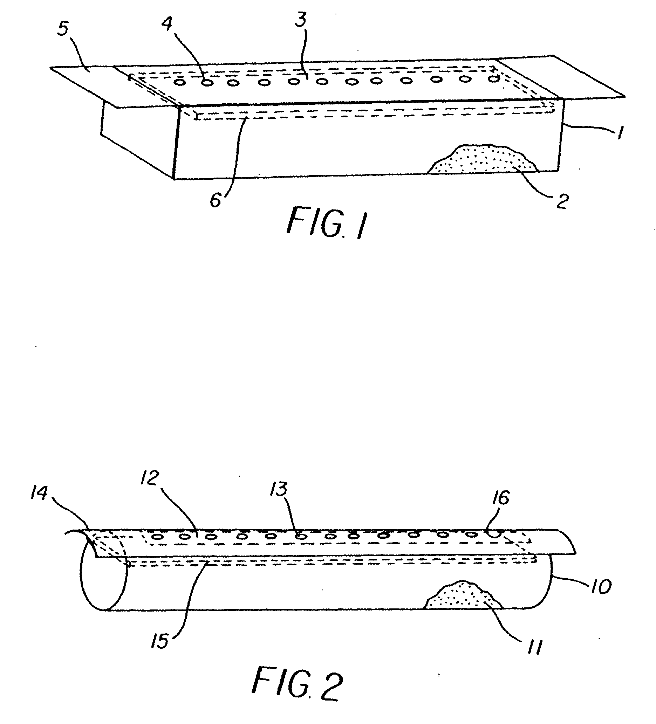

Turning to FIGs. 1 and 2, respectively perspective views of an elongated vapor deposition source having a rectangular cross section and having a circular cross section are shown. The source body or container 1,10 is filled with material 2, 11. A cover or lid 3, 12 seals the source body. In FIGs 1 and 2, apertures 4, 13 are located in a row along the central axis of the cover 3, 12. While the apertures are shown in the top surface, which is used to seal the container, the apertures need not be in the top surface, and the sealing surface (i.e. cover or lid) need not be the top surface of the container.

The apertures can be in any elongated pattern, including multiple rows, staggered or aligned, and they can be any shape, including circular, rectangular, elliptical, ovular, or square. Furthermore, the cover or lid can either seal to the source body directly or it may cover an opening such as the large slit 16 (shown by dotted lines) in FIG 2. Clamps or wires of a variety of kinds, such as tension bands, screwed vise clamps, internal flanges with bolts and tapped holes or external flanges with through holes and nuts, etc. can be used to affix the cover or lid in contact with the source body.

A baffle 6, 15 prevents particulate matter from being ejected towards the apertures and ensures that vapor exiting the apertures has collided with the internal surfaces of the container so the material flow is well established. The cover or lid can be electrically conductive and the body or container electrically insulating, or vice versa, or both can be insulating or both can be conductive. End contacts 5, 14 can be used for mechanical fixture and for making electrical contact to the top surface, when the top surface is used as a resistive heater. Alternatively, electrical feedthroughs (not shown) can be placed through a long surface of the container to make electrical contact to either the baffle 6, 15 or an additional heater internal to the source body (not shown). The surface with apertures can be heated separately from the baffle or with the baffle (or internal heating element) in serial or parallel fashion. Alternatively, the source can be radiantly heated by external means (not shown).

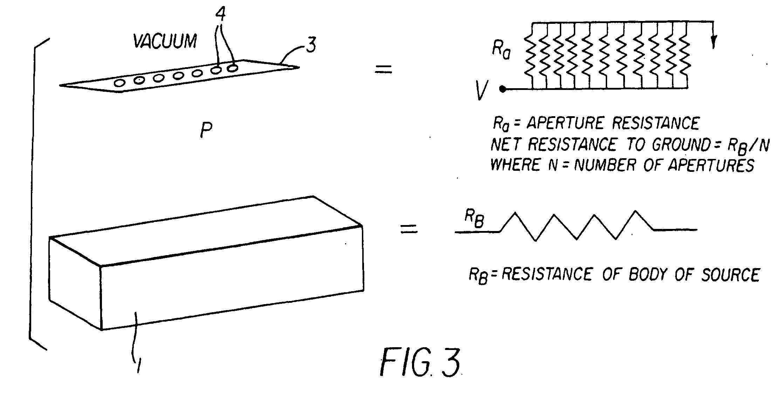

FIG. 3 illustrates how the source body and apertures can be represented as respective resistances $R_B$ and $R_a$. The source body is represented as one resistance $R_B$ and the apertures are represented as a plurality of parallel connected resistors $R_a$. The internal pressure P of the vapor in the source is analogous to the voltage V along one side of the parallel resistors $R_a$.

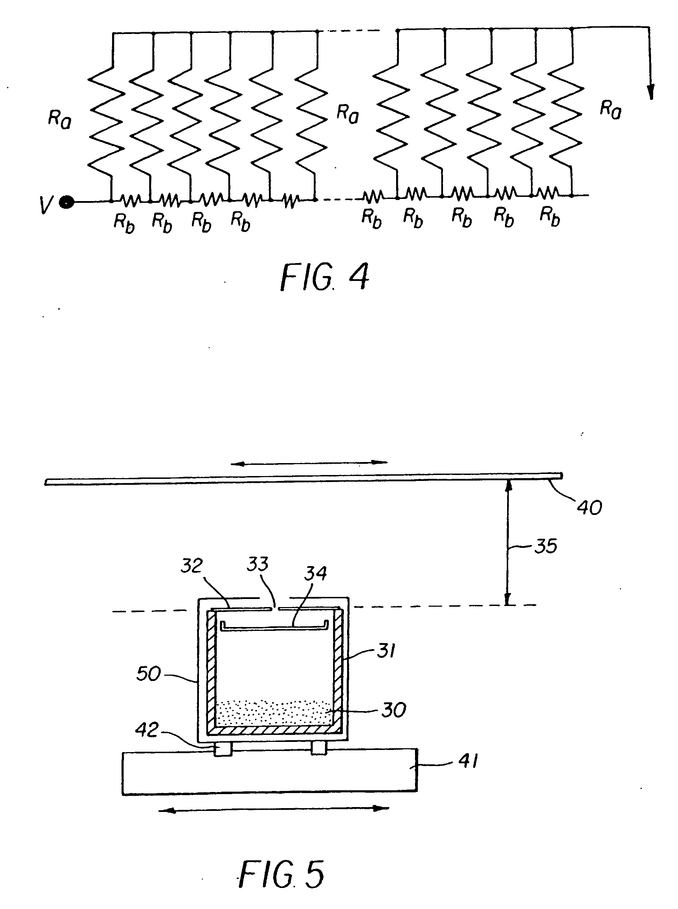

In a worst case, shown in FIG. 4, vapor is generated largely at one end of the source, corresponding to a voltage V being applied at one end of the parallel array of resistors $R_a$. Furthermore, each section of the source body has some resistance $R_b$ between apertures. The result is that the pressure drops along the length of the source, thereby causing non uniform deposition.

Now turning to FIG. 5, a material 30 to be deposited on substrate 40 is loaded into the source body 31. The source body can be made from a thermally insulating material or a thermally conductive material. It can also be electrically insulating or conducting. Furthermore, the source body can contain within it a crucible for holding material, said crucible being made from a thermally insulating material or a thermally conductive material. The terms "substrate" and "workpiece" as used herein denote a support on which a luminescent or otherwise photoactive device or array thereof is constructed. The term "structure" is used to describe the substrate once it has received a portion of a vapor deposited layer.

An aperture plate 32 serving as the emitting surface can be affixed to the source body as a separate piece and sealed thereto by use of fasteners and a high-temperature gasket material (for example, Grafoil™), by welding, or it can be an integral part of the source body itself. In the former case, the material can be loaded by removal of the aperture plate and any associated fixtures. In the latter cases, material must be loaded through an opening elsewhere that can later be sealed (for example, at the ends of the source body or an opening cut in the side of the source body). An array of apertures 33 located on the aperture plate 32 is employed to distribute the vaporized material 30 uniformly along the length of the source onto substrate 40. The spacing of the apertures can be tailored near the ends of the source in order to compensate for edge effects that generally cause lower deposited thickness at the edges of the substrate. The source-substrate distance 35 is defined as the vertical distance from the plane of the upper surface of the aperture plate 32 to the plane of the lower surface of the substrate 40.

A baffle 34 as disclosed by Spahn is used to prevent direct line of sight between vaporizing material 30 and the apertures 33. The baffle may also serve as the active heating element, or separate heating elements can be used, either internal to the source or by external radiative means. For example, the aperture plate can be electrically isolated and used as a resistive heating element. Alternatively, the baffle can be electrically isolated and used as a resistive heating element, or an additional heating element can be inserted between the baffle and aperture plate, or below the baffle. As yet another example, an external heater may also be used to provide a substantially uniform temperature within the interior of the elongated vapor deposition source.

Regardless of heating method, it may be advantageous to have one or more radiation shields 50 to ensure that the temperature of the exit surfaces of the apertures remains sufficiently high to prevent condensation thereon and to limit the temperature excursion of the substrate during the deposition process. Furthermore, such radiation shields can be used to reduce the input power required for achieving the desired vapor emission rate from the source.

To coat large areas, the source is made sufficiently long and then is translated relative to the substrate in the direction perpendicular to its long axis. For example, the source can be placed on standoffs 42 and affixed to a carriage 41, which can be motorized and passed underneath the substrate 40. Alternatively, the substrate fixture can be moved relative to a fixed source or both substrate and source can be moved to achieve the desired relative translation.

A key requirement for uniform deposition from an elongated source (such as depicted in FIGs. 1-5) is that the pressure distribution along the length of the source is repeatable. In general, if the pressure distribution is known, the apertures can be sized accordingly such that the product $C_i P_i$, i.e. the throughput from each aperture, is maintained constant along most of the source length and adjusted appropriately near the edges in order to compensate the edge effects associated with the finite length of the source (here, $C_i$ is the conductance of an aperture and $P_i$ is the pressure in the source at the aperture location.). The Conductances $C_i$ are the reciprocals of the resistances employed in the model described above. A special case of a repeatable pressure distribution is one that is nearly constant along the length of the source and, furthermore, is insensitive to nonuniform vaporization (from temperature non-uniformities), as well as flow-induced pressure gradients from vaporized material exiting the source via the apertures or leaks in the source other than the apertures.

To provide a substantially uniform and robust pressure within the source body, the relative conductance of the apertures and the body must be taken into account. By calculating conductances and considering a worst-case scenario for flow of the material vapor through the source body, a conductance criterion - i.e., that the ratio of the total conductance of all apertures to the conductance of the source body be below some value - emerges. The basis for the conductance criterion is explained below.

The mean free path in an ideal gas depends on temperature, pressure, and the molecular size (see J.M. Lafferty, ed, *Foundations of Vacuum Science and Technology*, Wiley & Sons, New York, 1998, p.8)

$$L = k_B T / (\sqrt{2} \cdot P \pi \cdot \delta^2)$$

where $L$ is in m, $k_B$ is the Boltzmann constant, $P$ is the pressure in Pa, and $\delta$ is the molecular diameter in m. A convenient form of this expression is

$$L = 5.3 \cdot 10^{-6} \cdot \frac{(T/273)}{(\delta/4)^2 \cdot (P/10^5)},$$

where $L$ is in cm, $T$ is in $K$, $\delta$ is in Å, and $P$ is in Pa. This form for $L$ is used to estimate the Knudsen number

$$K_n = L/d,$$

where d is a characteristic dimension in the system.

During the vapor deposition of organic materials using an elongated source such as described in this invention, the vaporized organic material is emitted from the emitting surface through a series of apertures. In general, these apertures are small enough in at least one dimension such that Knudsen number (i.e., the ratio of mean free path to said small dimension) exceeds the value 1 and the aperture is said to be in molecular flow.

In molecular flow, the conductance of an orifice (or aperture) having zero length is given by (see Lafferty, ibid p 86):

$$C_0 = A \sqrt{\frac{R_0 T}{2\pi M_m}},$$

where $A$ is the orifice area in m², $R_0$ is the universal gas constant, $T$ is the absolute temperature, and $M_m$ is the molar mass in kg. This expression is closely related to the emission rate discussed below. For air at 22 C, $C_0 = 11.6\ A$ in l/s and $A$ is in cm². For other gases at different temperatures, $C_0$ can be expressed as

$$C_0(l/s) = 11.6 \cdot A(cm^2) \cdot \sqrt{\frac{T(K)/293.16}{M_m(g)/28.8}}.$$

As the orifice size decreases, the thickness of the orifice walls becomes increasingly important. Eventually, the orifice becomes more like a duct. The molecular flow conductance of a duct is similar to that of the zero-length orifice, but is modified by the transmission probability:

$$C_a = \alpha \cdot A \sqrt{\frac{R_0 T}{2\pi M_m}}.$$

Here, $C_a$ is the conductance of an aperture of non-zero length. Transmission probabilities $\alpha$ for various geometries have been derived by various means. For certain simple geometries, analytical solutions can be found. For more complex geometries, Monte Carlo techniques are used. Values of $\alpha$ are tabulated for a variety of geometries, including short ducts of circular cross section and short ducts of rectangular cross section (see Lafferty, ibid, p. 91 and O'Hanlon, J. F, *A User's Guide to Vacuum Technology*, 2nd ed, John Wiley & Sons, New York, 1989, pp. 36-37).

The throughput Q for each aperture is given by:

$$Q = C_a P,$$

where $C_a$ is the conductance defined above, and P is the pressure drop across the orifice. Thus, uniform emission from an elongated source with a plurality of apertures requires that the pressure drop P across each aperture be as uniform as possible. As the organic vapor travels through the vapor source body to the apertures, the conductance to gas flow along the source body must be sufficient to maintain nearly constant pressure within the deposition source. By allowing the vapor to move freely along the source length, the adverse effects of localized non-uniform vaporization, as well as localized leaks in the source construction, will be minimized, and uniform deposition can be achieved.

The conductance $C_B$ along the vapor deposition source can be calculated by determining the molecular flow conductance along the source body, the viscous flow conductance along the source body, and the Knudsen number. As discussed in O'Hanlon (ibid pp. 26-27), depending on the Knudsen number, the conductance is either taken to be the molecular flow value ($K_n > 1$) or the viscous flow value ($K_n < 0.01$), or a linear combination of the two values ($0.01 < K_n < 1$).

For a long cylindrical tube of diameter *d* and length *l* in molecular flow, the transmission probability can be calculated analytically and the molecular flow conductance can be expressed as:

$$C(l/s) = 12.1 \frac{d^3(cm^3)}{l(cm)} \sqrt{\frac{T(K)/293.16}{M_m(g)/28.8}}.$$

For a long rectangular duct with minor width *b*, major width *a*, and length *l* (all in cm), the molecular flow conductance can be expressed as:

$$C(l/s) = 11.6 \cdot ba \cdot \left[ \frac{16}{3\pi^{3/2}} \frac{b}{l} \ln(\frac{4a}{b} + \frac{3b}{4a}) \right] \cdot \sqrt{\frac{T(K)/293.16}{M_m(g)/28.8}}$$

(Note that the convention adopted here for defining *a* and *b* is that used by O'Hanlon (ibid, page 35) and is the reverse of that used by Lafferty (op cit., page 90).

In viscous flow, the conductance of a duct increases linearly with the average pressure in the duct and inversely as the viscosity of the gas. For a long circular tube, the viscous flow conductance can be expressed as:

$$C(l/s) = 1.38 \cdot \frac{d^4(cm^4)}{l(cm)} \cdot <P> \cdot \frac{(\delta(\text{Å})/3.74)^2}{\sqrt{(T(K)/273.16) \cdot (M_m(g)/28.8)}},$$

where $\delta$ is the molecular diameter, which has been taken as 3.74 Å for air (Lafferty, ibid, p. 9, 34), and it has been assumed that the viscosity of the gas obeys the following relationship (see O'Hanlon, op cit. p.17)

$$\eta \propto \frac{\sqrt{M_m \cdot k_B T}}{\delta^2}.$$

For a long rectangular duct in viscous flow, the conductance can be expressed as (see Lafferty op cit. p. 111 and O'Hanlon op cit. p. 31):

$$C(l/s) = 4.6 \cdot [a^3 b^3 / (a^2 + b^2 + 0.371 \cdot a \cdot b)] \frac{<P>}{l} \frac{(\delta(\text{Å})/3.74)^2}{\sqrt{(T(K)/293.16) \cdot (M_m(g)/28.8)}}$$

where *a*, *b*, and *l* are in cm and are as defined previously for rectangular ducts, and <P> is the average pressure in the duct in Pa.

The method disclosed here relies upon comparing the aperture and boat conductances and is not specific to which conduction regime is in effect. In the examples disclosed herein the geometries, molecular properties, temperatures, and pressure ranges are such that the orifices are short ducts in molecular flow, while the source body is treated as a long duct in molecular, transition, or viscous flow (depending on cross sectional dimensions, pressure, molecular size, and temperature). Furthermore, in the case of materials such as aluminum tris-quinolate (AlQ), the corrections for $T$, $M_m$, and $\delta$ are significant — the molecular flow conductance is reduced considerably (relative to air at 20 C) by the high molecular mass (and hence slower thermal velocity relative to air), while the viscous flow is slightly increased by the net decrease in viscosity, even with the increase in molecular mass and temperature (see the viscosity relationship above).

In order to determine the viscous flow conductance, the average pressure in the vapor deposition source must be known. The operating pressure of the linear source can be estimated from known deposition rates at a known distance from the source. A simple estimate can be made treating the source as a line source. Applying Gauss' law and making use of the cylindrical symmetry of the situation, one finds that the deposition rate r directly above the center of the source depends inversely on the distance d from source to substrate:

$$r = \frac{Q}{\pi \cdot l \cdot d}.$$

Here, Q is the mass per unit time emitted from the source of length 1, and it has been assumed that the source emits into the semi cylinder of radius d. The factor of πd arises from the integral of the isotropic flux density over the surface of the semi-cylinder.

This estimate can be improved by taking into account the emission profile of the source (see Lafferty op cit. pp. 85-86). For thin apertures, the emission profile follows a cos(θ) distribution (the magnitude of the flux density emanating from the source at an angle θ with respect to the normal to the plane of the source is proportional to cos (θ)). For emission from deeper structures (i.e., thick apertures or tubes) the flux density is significantly more anisotropic - the larger the ratio of the length of the opening to the lateral dimension, the more beam-like the emission (see Lafferty ibid, p. 86).

At sufficiently low operating pressures within the source, the flow through the apertures can be considered to be molecular flow, and the beaming effects (i.e. flow that appears more like a beam of particles as opposed to a cloud) are approximated by introducing a factor of cos $^p(\theta)$, where p is a power empirically determined to account for the resultant deposition profile. At higher operating pressures, the flow through the apertures may have a significant contribution from viscous flow. In this case as well, the ratio of length of opening to the lateral dimension influences the degree of beaming.

With a higher degree of beaming, the source material is used more efficiently to produce a coating directly above the source (the contribution to the integral of the flux density over the surface of the semi-cylinder is significantly greater for small values of θ than for larger values of θ). From the measured deposition rate directly over the center of the elongated source at a specified distance from the source to the substrate, the estimated flux density emanating from the source is given as follows:

$$q/l = r \cdot 10^{-8} \rho \cdot \cdot I \cdot d, \text{ where } I = \int_{-\frac{\pi}{2}}^{\frac{\pi}{2}} \cos^p(\theta)\, d\theta$$

Here, $q/l$ is in g/cm/s, r is in (Å/s), d is the distance from the center of the source to the substrate in cm, and the mass density p of the coating is assumed to be 1 g/cm³. This expression is valid when d is large compared to the lateral distance over which the deposition rate is sampled. For measurements of r over a flat substrate with edge dimension $x$ cm, the expression for $I$ is:

$$I = \cfrac{\displaystyle\int_{-\frac{\pi}{2}}^{\frac{\pi}{2}} \cos^P(\theta)\,d\theta}{\cfrac{1}{x}\displaystyle\int_{-\frac{x}{2}}^{\frac{x}{2}} \cos^{P+2}(\theta(x'))\,dx'} \; ,$$

where $\theta(x)$ is the angle between the vector from the source axis to a point at x on the substrate and the normal to the source axis (pointing to x=0). The extra powers of $\cos(\theta)$ in the integral in the denominator arise from taking the dot product of the flux density vector with the substrate surface normal and from the change in distance to the source as a function of x.

The pressure in a source emitting material at rate $q$ is calculated assuming that the source material is at equilibrium vapor pressure:

$$P = q \cdot \frac{N_A}{A_o M_w}\sqrt{2k_B T\pi m} \; .$$

Here, $q$ is the material emission rate in g/s, $A_o$ is the total aperture area in m2, T is the temperature in Kelvin of the vapor of material being deposited, $M_w$ is the molecular weight of the material being deposited (in amu), m is the mass in kg of a molecule of the material being deposited, $N_A$ is Avogadro's number, and $k_B$ is the Boltzmann constant. The pressure thus calculated is in Pascal. This expression is valid for orifices having zero wall thickness (i.e., in the limit that the orifice/heater plate is much thinner than the orifice dimension).

In this calculation, the rate of emission of material from the source is taken from kinetic theory (Lafferty op cit. pp. 18-21) and depends on the density $n$ and thermal velocity $v_T$ of the source vapor:

$$\text{Emission rate (molec./s)} = (\frac{n v_T}{4})A,$$

where A is the orifice area, and the thermal velocity is taken from the kinetic theory of gases:

$$v_T = \sqrt{8k_B T / \pi m} \; .$$

For non-zero aperture thickness, the expression above must be divided by the transmission probability $\alpha$ for an individual orifice, which is now treated as a short duct in molecular flow:

$$P = \frac{q}{\alpha} \cdot \frac{N_A}{A_o M_w}\sqrt{2k_B T\pi m} \; .$$

For operation at higher pressures, one must consider transition and viscous flow through the apertures. While the example presented here is for molecular flow through the apertures, it should be readily apparent to those skilled in the art that the emission from the source and the conductance of the apertures can be modified for the cases of transition and viscous flow, and thus the respective determination of operating pressure and aperture conductance can be made for the cases where the apertures are not in molecular flow.

A worst-case scenario for non-uniform vaporization is if the vapor enters the source from only one end (similar to loading the solid material only on one end of the source). The resultant pressure drop can then be calculated as a function of source geometry and deposition rate.

As described above, given the deposition rate, the distance from source to substrate, and the material being deposited, a source emission rate is calculated. The emission rate and the orifice geometry (hence, the transmission probability) are then used to calculate the source pressure. The vaporization curve of the material (see. Lafferty, ibid., pp. 22 - 25 for a discussion of vapor pressure) is then used to estimate the gas temperature within the source. The source pressure is then adjusted using the new value for temperature. Generally this process converges in only a few iterations, as vaporization curves have very strong temperature dependences, and only a small change in temperature is required to produce a rather large change in pressure.

From the calculated source pressure and temperature, the conductance of the source body is then calculated by treating it as a long hollow tube. (The internal baffle is neglected in this calculation, but the upper surface of the material loaded into the source is considered to be one of the walls of the source body. Conductances are calculated for both the full source and the empty source.) A simple conductance ratio is calculated by taking the sum of the conductances of all the apertures, i.e. $N \times C_a$, where N is the number of apertures, and dividing that sum by the conductance along the source body. For a variety of deposition rates and source geometries, the effect on the simple conductance ratio can be assessed.

As the elongated vapor deposition source consists of an enclosure with exit apertures, it lends itself to treatment as a gas distribution manifold. As a limiting case, one can consider the material to be deposited as entering as a vapor from one end of the source, with the other end of the source closed off. Coating uniformity thus depends critically on pressure uniformity along the length of the source. This scenario is a worst-case scenario and would correspond to an extremely non-uniform vaporization of the source material, either from localized intense heating, or from non-uniform distribution of material (e.g., all source material loaded at one end of the boat). Hence, the ability to maintain constant pressure along the source body in the presence of localized heating or non-uniform distribution of material translates to the ability of a gas delivery manifold to operate at constant pressure along its length.

The elongated vapor deposition source can be considered a series of segments, each with an exit aperture and a short tube length. The short lengths of tube are considered to be resistances (resistance = 1/conductance) in series, which form one side of a ladder network. The exit orifices are parallel resistances to ground (vacuum), which form the rungs of the ladder (see FIGs. 3 and 4). Because of the considerable orifice effects for short ducts (see O'Hanlon op cit. pp. 45-47), the series resistances are taken to be the net resistance of the source body divided by the number of segments, rather than the resistance that would be calculated from the conductance of an individual segment, thus $C_b = N \times C_B$. (Here, the number of segments N is the number of exit apertures, assumed to be equally spaced for the purposes of calculating the conductance ratio $C_A/C_B$.)

By an iterative procedure, the net conductance of the entire ladder network is calculated. (The first orifice is added in series with the first segment body. That pair is added in parallel with the next orifice. The next segment body is added in series with the previous net conductance. The next orifice is added in parallel with the new net conductance, and so on.) The input mass flow to the manifold is calculated from the required average deposition rate. By a similar iterative procedure, the integrated flow through the orifices and the pressure (in the source body segments) are calculated along the length of the network. The inlet pressure is then adjusted so that the average pressure in the source body corresponds to that required to obtain the specified deposition rate. The pressure difference from the inlet to the opposite end of the source is then divided by the average pressure to obtain the pressure nonuniformity along the source body.

In order to assess sensitivity to leaks, the ladder network was modified to include a leak conductance on the end opposite that from which the vapor enters. The net pressure nonuniformity is then calculated by taking the pressure difference from inlet to leak and dividing by the average pressure. This value includes both the effects of the flow through the apertures and the flow induced by the leak.

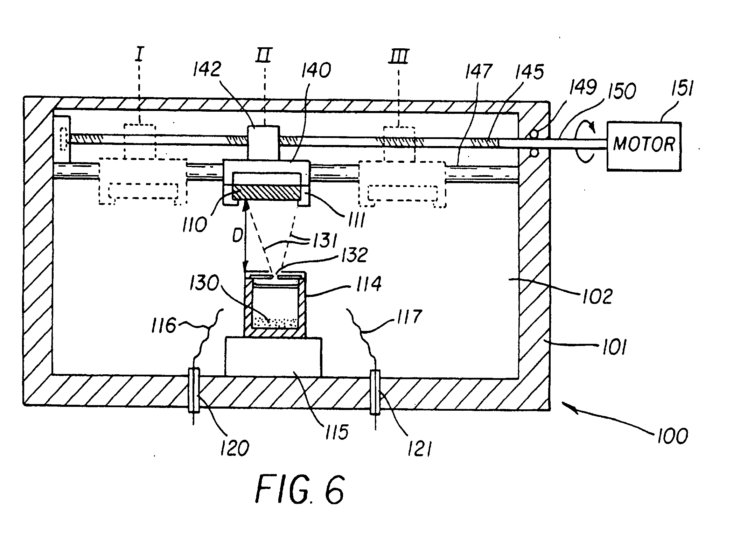

Large-area coating using the present invention can be implemented for coating of layers used in making OLEDs and other optically active devices. As an example, FIG. 6 shows a schematic sectional view of a vapor deposition system of the present invention. The vapor deposition station 100 has a housing 101, which defines a chamber 102. A substrate or structure 110 is supported in a holder and/or in a mask frame 111 within the chamber 102 which is at reduced pressure, typically at a pressure lower than 0.13 Pa.

The thermal physical vapor deposition source 114 is supported by a thermally and electrically insulating source support 115. Electrical leads 116 and 117 are schematically shown directed toward the source from respective power feedthroughs 120 and 121 disposed in the housing 101.

In FIG. 6, relative motion between the substrate or structure 110 and the vapor deposition source, during vapor deposition of material 130 in a deposition zone 131 of vaporized material, is provided by moving or translating the substrate or structure 110 with respect to the source. The vapor deposition source, i.e. the plurality of apertures 132, has a spacing D from the substrate or structure 110.

In an intermediate vapor deposition position "II", the substrate or structure 110, the holder and/or mask frame 111, a glide shoe 140, and a lead screw follower 142 are shown in solid-outline sectional view. These source elements are depicted in dotted and dashed outlines in a left position "I" of the holder 111, and in right position "III" of the holder, these positions being respectively the start and finish of a rightward motion of the holder or the finish and start of a leftward motion of the holder..

Leftward and rightward motion is effected by a lead screw 145 which engages the lead screw follower 142. The follower 142 is attached to the glide shoe 140, which, in turn, supports the holder and/or mask frame 111. The glide shoe 140 glides along a glide rail 147. The lead screw shaft 150 extends through the housing 130 and shaft seal 149 to a motor 151.

The motor 150 provides for leftward or rightward motion or idling (no motion) in a designated position in which a substrate or structure 110 with a completed organic layer is removed from the holder and/or mask frame 111 and a new substrate or structure is positioned in the holder.

In FIG. 6, the substrate or structure 110 is moved with respect to a stationary elongated vapor deposition source in a direction substantially perpendicular to the elongated direction of the source. Alternatively, relative motion between the substrate or structure 110 and the elongated vapor deposition source can be provided by moving the source with respect to a stationary substrate or structure by a lead screw which engages a movable carriage or other movable transport means on which the elongated vapor deposition source can be positioned.

The elongated thermal physical vapor deposition source of the present invention can also be effectively used to form a uniform layer of one or more organic host materials and one or more organic dopant materials by vapor deposition from one elongated source having a plurality of vapor efflux apertures. The host matcrial(s) and the dopant material(s) are received in an elongated container 2,11,31 in the form of powders, flakes, or particles, or in the form of agglomerated pellets.

The invention and its advantages are further illustrated by the following specific examples.

### Example 1

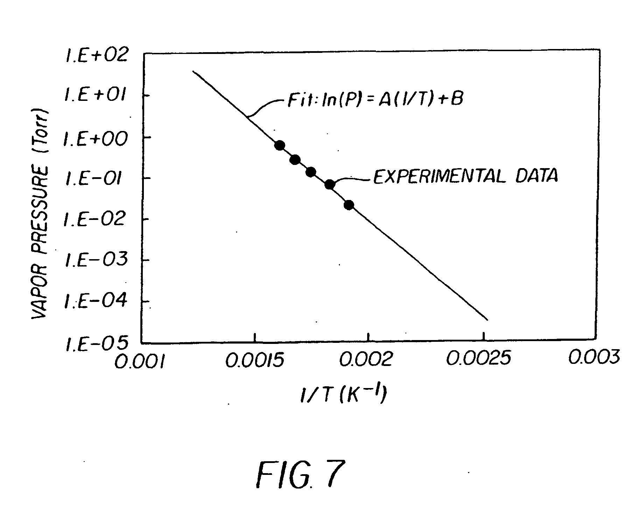

A 60 cm long source is covered with an aperture plate and heater assembly having 60 apertures with their centers spaced 0.9 cm apart, starting 2.55 cm from the end of source. The apertures are rectangular slots 0.0125 cm wide x 0.5 cm long. The source body is rectangular in cross section, having width b and depth a, where the depth a denotes the distance from the aperture plate to the surface of the material loaded in the source. The deposition rate is 50 A/s at an aperture-substrate distance of 12 cm, and the material being vaporized is aluminum tris-quinolate (AlQ) (having a molecular mass of 459, a molecular diameter of 1 nm, and a vapor pressure curve as given in FIG. 7). Values for a and b are shown in Table I. The conductance ratio is calculated for the required operating pressure to produce the specified rate and is shown in Table I. The pressure nonuniformity is calculated as described above. Results are shown in Table I for the case where there are no leaks (other than the apertures) and for the case where there is a leak at one end of the source, said leak having a conductance equal to the total conductance of all the apertures.

Table I

| Source Width, b (cm) | Source depth, a (cm) | Source Length (cm) | Conductance Ratio: $\dfrac{C_{apertures}}{C_{source\,body}}$ ($C_A/C_B$) | Pressure nonuniformity $100\dfrac{(P_{max}-P_{min})}{(P_{max}+P_{min})/2}$ | Pressure nonuniformity with leak $C_{leak}=C_A$ |
|---|---|---|---|---|---|
| 0.611 | 2.54 | 60 | 2.01 | 87.4 | 154.3 |
| 0.8 | 2.54 | 60 | 1.03 | 48 | 102.1 |
| 1 | 2.54 | 60 | 0.59 | 28.6 | 68.4 |
| 2 | 2.54 | 60 | 0.12 | 6 | 16.9 |
| 2.54 | 2.54 | 60 | 0.078 | 3.9 | 11.3 |
| 2.54 | 3 | 60 | 0.058 | 2.9 | 8.4 |
| 2.54 | 3.5 | 60 | 0.044 | 2.2 | 6.4 |
| 2.54 | 4 | 60 | 0.035 | 1.8 | 5.2 |

### Example 2

A 60 cm long source is covered with an aperture plate and heater assembly having 60 apertures with their centers spaced 0.9 cm apart, starting 2.55 cm from the end of source. The apertures are rectangular slots 0.0125 cm wide x 0.5 cm long. The source body is rectangular in cross section, having width b and depth a, where the depth a denotes the distance from the aperture plate to the surface of the material loaded in the source. The deposition rate is 10 A/s at an aperture-substrate distance of 12 cm, and the material being vaporized is aluminum tris-quinolate (AlQ) (having a molecular mass of 459, a molecular diameter of 1 nm, and a vapor pressure curve as given in FIG. 7). Values for a and b are shown in Table II. The conductance ratio is calculated for the required operating pressure to produce the specified rate and is shown in Table II. The pressure nonuniformity is calculated as described above. Results are shown in Table II for the case where there are no leaks (other than the apertures) and for the case where there is a leak at one end of the source, said leak having a conductance equal to the total conductance of all the apertures.

Table II

| Source Width, b (cm) | Source depth, a (cm) | Source Length (cm) | Conductance Ratio: $\frac{C_{apertures}}{C_{source body}}$ ($C_A$/$C_B$) | Pressure nonuniformity $100\frac{(P_{max}-P_{min})}{(P_{max}+P_{min})/2}$ | Pressure nonuniformity with leak $C_{leak}=C_A$ |
|---|---|---|---|---|---|
| 0.611 | 2.54 | 60 | 4.55 | 169.6 | 232.6 |
| 0.8 | 2.54 | 60 | 2.62 | 109 | 178 |
| 1 | 2.54 | 60 | 1.65 | 73.5 | 137.8 |
| 2 | 2.54 | 60 | 0.400 | 19.7 | 50 |
| 2.54 | 2.54 | 60 | 0.254 | 12.6 | 33.8 |
| 2.54 | 3 | 60 | 0.189 | 9.5 | 26 |
| 2.54 | 3.5 | 60 | 0.146 | 7.3 | 20.5 |
| 2.54 | 4 | 60 | 0.118 | 5.9 | 16.7 |

## Example 3

A 60 cm long source is covered with an aperture plate and heater assembly having 60 apertures with their centers spaced 0.9 cm apart, starting 2.55 cm from the end of source. The apertures are rectangular slots 0.0125 cm wide x 0.5 cm long. The source body is rectangular in cross section, having width b and depth a, where the depth a denotes the distance from the aperture plate to the surface of the material loaded in the source. The deposition rate is 1 A/s at an aperture-substrate distance of 12 cm, and the material being vaporized is aluminum tris-quinolate (AlQ) (having a molecular mass of 459, a molecular diameter of 1 nm, and a vapor pressure curve as given in FIG. 7). Values for a and b are shown in Table III. The conductance ratio is calculated for the required operating pressure to produce the specified rate and is shown in Table III. The pressure nonuniformity is calculated as described above. Results are shown in Table III for the case where there are no leaks (other than the apertures) and for the case where there is a leak at one end of the source, said leak having a conductance equal to the total conductance of all the apertures.

Table III

| Source Width, b (cm) | Source depth, a (cm) | Source Length (cm) | Conductance Ratio: $\frac{C_{apertures}}{C_{source body}}$ ($C_A$/$C_B$) | Pressure nonuniformity $100\frac{(P_{max}-P_{min})}{(P_{max}+P_{min})/2}$ | Pressure nonuniformity with leak $C_{leak}=C_A$ |
|---|---|---|---|---|---|
| 0.611 | 2.54 | 60 | 5.71 | 200.1 | 257.7 |
| 0.8 | 2.54 | 60 | 3.67 | 143.7 | 210.3 |
| 1 | 2.54 | 60 | 2.56 | 107.5 | 175.9 |
| 2 | 2.54 | 60 | 0.863 | 40.9 | 90.5 |
| 2.54 | 2.54 | 60 | 0.589 | 28.5 | 68.1 |
| 2.54 | 3 | 60 | 0.457 | 22.3 | 55.7 |
| 2.54 | 3.5 | 60 | 0.361 | 17.8 | 45.9 |
| 2.54 | 4 | 60 | 0.296 | 14.7 | 38.7 |

## Example 4

A 60 cm long source is covered with an aperture plate and heater assembly having 60 apertures with their centers spaced 0.9 cm apart, starting 2.55 cm from the end of source. The apertures are circular holes having a 0.04 cm diameter. The source body is rectangular in cross section, having width b and depth a, where the depth a denotes the distance from the aperture plate to the surface of the material loaded in the source. The deposition rate is 50 A/s at an aperture-substrate distance of 12 cm, and the material being vaporized is aluminum tris-quinolate (AlQ) (having a molecular mass of 459, a molecular diameter of 1 nm, and a vapor pressure curve as given in FIG. 7). Values for a and b are shown in Table IV. The conductance ratio is calculated for the required operating pressure to produce the specified rate and is shown in Table IV. The pressure nonuniformity is calculated as described above. Results are shown in Table IV for the case where there are no leaks (other than the apertures) and for the case where there is a leak at one end of the source, said leak having a conductance equal to the total conductance of all the apertures.

Table IV

| Source Width, b (cm) | Source depth, a (cm) | Source Length (cm) | Conductance Ratio: $\frac{C_{apertures}}{C_{source\,body}}$ ($C_A/C_B$) | Pressure nonuniformity $100\frac{(P_{max}-P_{min})}{(P_{max}+P_{min})/2}$ | Pressure nonuniformity with leak $C_{leak}=C_A$ |
|---|---|---|---|---|---|
| 0.611 | 2.54 | 60 | 0.427 | 20.9 | 52.7 |
| 0.8 | 2.54 | 60 | 0.219 | 10.9 | 29.6 |
| 1 | 2.54 | 60 | 0.126 | 6.3 | 17.8 |
| 2 | 2.54 | 60 | 0.0254 | 1.3 | 3.8 |
| 2.54 | 2.54 | 60 | 0.0156 | 0.8 | 2.3 |
| 2.54 | 3 | 60 | 0.0114 | 0.6 | 1.7 |
| 2.54 | 3.5 | 60 | 0.00869 | 0.44 | 1.3 |
| 2.54 | 4 | 60 | 0.00696 | 0.35 | 1 |

## Example 5

A 30 cm long source is covered with an aperture plate and heater assembly having 30 apertures with their centers spaced 0.9 cm apart starting 0.96 cm from the end of source. The apertures are rectangular slots 0.0125 cm wide x 0.5 cm long. The source body is rectangular in cross section, having width b and depth a, where the depth a denotes the distance from the aperture plate to the surface of the material loaded in the source. The deposition rate is 10 A/s at an aperture-substrate distance of 12 cm, and the material being vaporized is aluminum tris-quinolate (AlQ) (having a molecular mass of 459, a molecular diameter of 1 nm, and a vapor pressure curve as given in FIG. 7). Values for a and b are shown in Table V. The conductance ratio is calculated for the required operating pressure to produce the specified rate and is shown in Table V. The pressure nonuniformity is calculated as described above. Results are shown in Table V for the case where there are no leaks (other than the apertures) and for the case where there is a leak at one end of the source, said leak having a conductance equal to the total conductance of all the apertures.

Table V

| Source Width, b (cm) | Source depth, a (cm) | Source Length (cm) | Conductance Ratio: $\frac{C_{apertures}}{C_{source\,body}}$ ($C_A/C_B$) | Pressure nonuniformity $100\frac{(P_{max}-P_{min})}{(P_{max}+P_{min})/2}$ | Pressure nonuniformity with leak $C_{leak}=C_A$ |
|---|---|---|---|---|---|
| 0.611 | 2.54 | 30 | 1.39 | 63.9 | 124.6 |
| 0.8 | 2.54 | 30 | 0.810 | 38.9 | 86.7 |
| 1 | 2.54 | 30 | 0.514 | 25.3 | 61.4 |
| 2 | 2.54 | 30 | 0.128 | 6.5 | 18.2 |
| 2.54 | 2.54 | 30 | 0.0817 | 4.2 | 11.9 |
| 2.54 | 3 | 30 | 0.0611 | 3.1 | 9 |
| 2.54 | 3.5 | 30 | 0.0472 | 2.4 | 7 |
| 2.54 | 4 | 30 | 0.0381 | 2 | 5.7 |

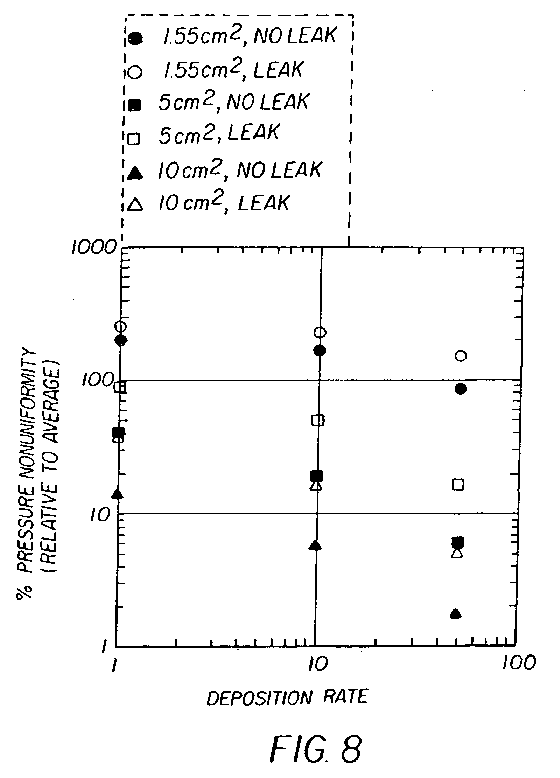

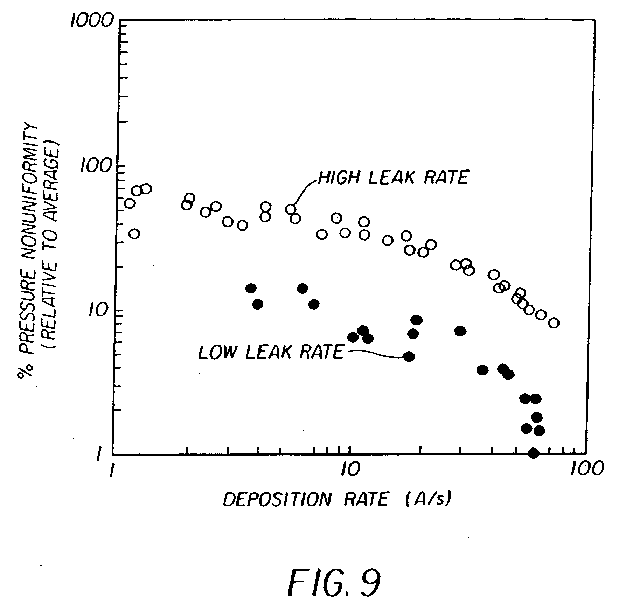

Experimental data are provided in FIG. 9 for comparison with the example calculations, specifically Fig 8, where pressure nonuniformity vs. deposition rate data is plotted for different cross-sectional areas with and without end leaks from Examples 1 - 5. In the experiment, a source of 50 cm length was filled with material (AlQ) such that its body cross sectional area was roughly 10 cm$^2$. An aperture plate and heater assembly with a series of 49 rectangular apertures, 0.0125 cm wide by 0.5 cm long was used with this source body. Near the center of the source, the centers of the apertures were spaced roughly 1 cm apart. The apertures near the edges were spaced more closely together to compensate for edge effects in the uniformity profile (as disclosed by Freeman et al, EP Application, Serial No. 03075554.0, filed February 26, 2002). This particular construction had zones near the ends where the operating temperatures were significantly cooler than the central region (by roughly 25 C).

On initial warm-up of the source, material condensing at the source ends produced a significant mass flow that simulated an effective leak at both ends of the source. An array of quartz crystal monitors placed 10 cm above the source along its length recorded the rate profile, and thus the uniformity profile of material emanating from the source. Nonuniformity was thus measured as a function of source operating rate (i.e., deposition rate in Å/s). An initial set of data was taken during the first warm-up of the source. After hours of operation, material accumulated at the ends of the source to such an extent that it was closer to the heater assembly, and therefore more effectively heated, thereby reducing the effective leak arising from the condensation effects. At this point the source operation was stable, and nonuniformity data were acquired as a function of operating rate. As can be seen from FIG. 8, the data are consistent with the calculations presented in the examples.

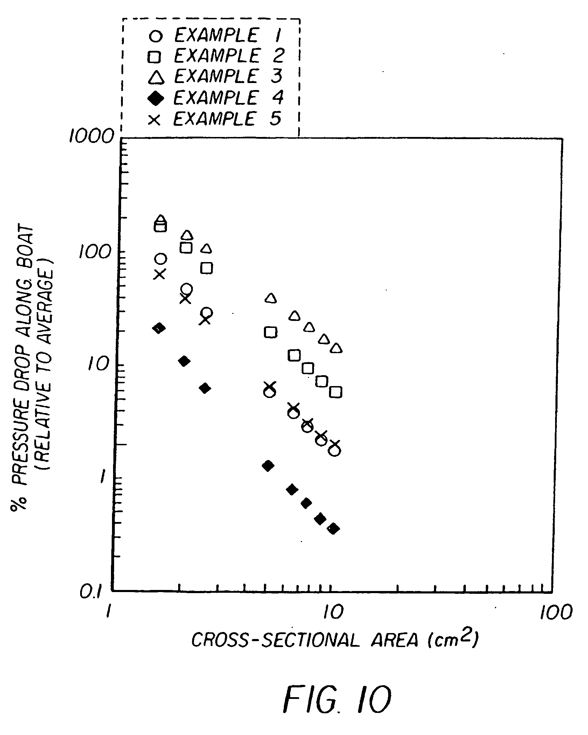

The above examples illustrate the dependence of source performance (% Pressure Nonuniformity) on source body cross sectional area and operating rate of the source. A graph summarizing the calculated pressure drops from all the examples as a function of the cross-sectional area of the source body is shown in FIG. 10. Prior to this invention, those skilled in the art would construct sources of varying body dimensions and aperture sizes and then empirically select the appropriate geometry based on desired uniformity and the required rate range. While the rate dependence of uniformity would not be entirely obvious to those skilled in the art, the general procedure of source optimization would accommodate this phenomenon by sizing the source body and apertures for the intended deposition rates and intended substrate sizes to be coated.

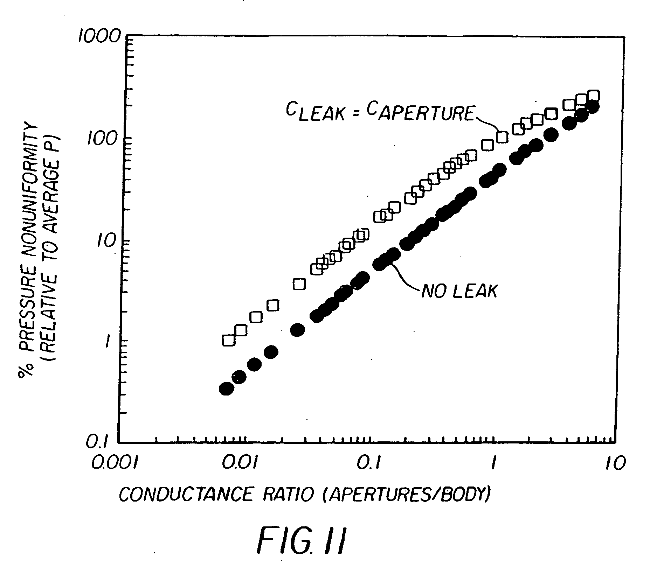

The examples presented above, when analyzed in terms of a single parameter — the conductance ratio, illustrate that robust source operation can be achieved by design according to the present invention. Shown in FIG. 11 are all the data for pressure nonuniformity as a function of conductance ratio for all the examples presented above. As can be seen from the graph, the previously demonstrated rate dependence and geometrical dependence of performance (see Tables I - V and FIG. 10) are accounted for entirely by the conductance ratio. As long as the conductance ratio is below a specified value, the performance will equal or exceed the specified uniformity requirements. In the examples presented above, the mechanism by which uniformity worsens at lower rates is the loss of viscous flow contribution to the conductance along the source body. Specifying source body and aperture geometries to work in this low-rate (molecular flow) limit will produce sources that perform over a much wider range of rates than can be achieved by constructing a source that just meets uniformity requirements at high rates and then operating the source at lower rates.

By this approach, a single source body and aperture construction can be devised to perform at all rates above a specified minimum rate and below some practical limit determined by the operating temperatures at high rates (and thus high pressures) as dictated by the vapor pressure curve for the material being deposited.

In accordance with the present invention, a source can be designed to work in the low-pressure limit of molecular flow by appropriate control of conductance ratio through aperture size and source body cross sectional dimensions. This novel approach avoids the need for multiple sources for differing ranges of required deposition rate.

Also, in accordance with the present invention, a source can also be designed to have the appropriate conductance ratio by providing a suitable pressure of inert gas, such as argon, in the source body. This approach would be advantageous in cases where there are significant restrictions on the maximum source body dimensions or significant limitations on the ability to produce sufficiently small apertures. This approach boosts the source operating pressure, thereby attaining transition or viscous flow along the source axis. Because this pressure is achieved by means other than increasing the vapor pressure (or partial pressure Pm) of the material to be deposited (i.e. by heating the material further), it has additional advantages for materials that are highly susceptible to thermal degradation. Geometrical restrictions and thermal degradation notwithstanding, in the case where a source operates well (i.e., with satisfactorily low non-uniformity) at high rates but not at low rates, an inert gas can be introduced to the source body to maintain some viscous flow in the source body down to the lowest rates required. This approach avoids the need to construct a different source with smaller apertures to limit the rate resulting from the need to operate at high vapor pressures to achieve suitable uniformity.

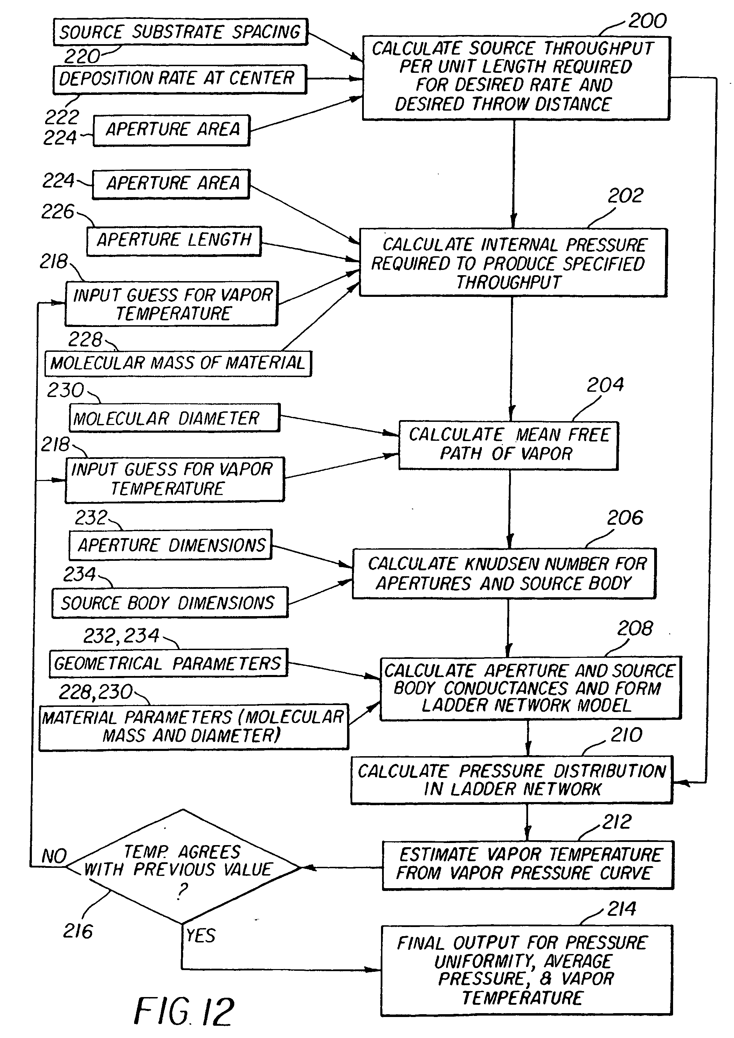

A flow chart summarizing the calculation of conductances and pressure distribution for a given deposition rate and geometry (as described in detail earlier and as used to generate the examples presented above) is shown in FIG. 12. First, a source throughput per unit length required for a desired deposition rate 222 at a desired source-substrate spacing 220 and a given total aperture area 224 is calculated 200. Next, using the individual aperture area 224 and aperture length 226, an initial guess of vapor temperature 218, and the molecular mass of the material 228, the internal pressure required to produce the throughput 200 is calculated 202. Using a molecular diameter 230, the guess of the temperature 218, and the internal pressure 202 are used to calculate a mean free path 204. The aperture dimensions 232 and the source body dimensions 234 are used in combination with the mean free path 204 to calculate a Knudsen number 206. The dimensions 232 and source body dimensions 234 as well as the molecular mass 228 and molecular diameter 230 are used with the appropriate conductance formula chosen based on the calculated Knudsen number to determine the respective aperture and source body conductances and a ladder network model is formed 208. Pressure distribution in the ladder network is calculated 210. Vapor temperatures are estimated 212 from a vapor pressure curve. The estimate 212 of the temperature is compared 216 to the initial guess 218. If the estimate 212 is significantly different (e.g. more than 2% of absolute temperature) from the initial guess 218, the guess is updated to equal the estimate and the calculations are repeated until the guess and the estimate are in agreement. A final value for pressure uniformity, average pressure, and vapor temperature is then output 214. For given material, deposition geometry, and deposition rate, this process is repeated for a variety of aperture and source body dimensions to produce graphs like those shown in Figs. 10 and 11. A suitable design is then chosen from these graphs.

**Claims**

1. A method for coating a large-area substrate, comprising the steps of:

   a) loading a material to be deposited on a workpiece into an elongated container, the container having a conductance $C_B$ in the elongated direction;
   b) heating the material in the container to vaporize the material to a partial pressure Pm;
   c) the container defining one or more apertures in an elongated pattern in the elongated direction for emitting the vaporized material through the apertures, the one or more apertures having a conductance $C_A$; wherein $\dfrac{C_A}{C_B} \leq 0.5$ , and
   d) providing relative motion of the substrate and elongated container in a direction substantially perpendicular to the elongated direction.

2. The method claimed in claim 1, wherein the emission through the apertures is by molecular flow and Pm $\leq$ 13 Pa.

3. The method claimed in claim 1, wherein the emission through the apertures is by viscous or transition flow and Pm > 13 Pa.

4. The method claimed in claim 1, wherein the container has a cover having apertures, and further comprising a baffle between the cover and the material to prevent vaporized material from passing through the apertures in the cover without first engaging the walls of the container.

5. The method claimed in claim 1, wherein $\dfrac{C_A}{C_B} \leq 0.1$ over a desired range of operation.

6. The method claimed in claim 1, wherein the apertures have varying size, shape or spacing between adjacent apertures, or combinations thereof, selected to provide a substantially uniform efflux of vaporized material along the elongated direction of the container.

7. The method claimed in claim 1, wherein the method is used to make an OLED.

8. The method claimed in claim 1, wherein the solid organic material received in the container includes doped or undoped organic hole-injecting material, doped or undoped organic hole-transporting material, doped or undoped organic light-emitting material, or doped or undoped organic electron-transporting material.

9. The method claimed in claim 1, further comprising the step of introducing an inert gas into the container to decrease $\dfrac{C_A}{C_B}$

10. The method claimed in claim 9, wherein the inert gas is argon or nitrogen.

11. The method claimed in claim 1 wherein the material is a phosphorescent material, an electroluminescent material, photoconducting, or luminescent by action of ionizing radiation.

**Patentansprüche**

1. Verfahren zum Beschichten eines großflächigen Substrats, mit den Schritten:

   a) Einlegen eines auf einem Werkstück abzulegenden Materials in einen lang gestreckten Behälter, der in Längsrichtung einen Leitwert $C_B$ aufweist;

   b) Erwärmen des Material im Behälter, um es mit einem Teildruck Pm zu verdampfen;

   c) wobei der Behälter eine oder mehrere Öffnungen in einem sich in Längsrichtung erstreckenden länglichen Muster aufweist zum Ausstoßen des verdampften Materials durch die Öffnungen, wobei die eine Öffnung oder die mehreren Öffnungen einen Leitwert $C_A$ haben, wobei $\frac{C_A}{C_B} \leq 0.5$ ; und

   d) Erzeugen einer Relativbewegung des Substrats und des lang gestreckten Behälters in einer zur Längsrichtung im wesentlichen rechtwinklig verlaufenden Richtung.

2. Verfahren nach Anspruch 1, worin der Ausstoß durch die Öffnungen durch molekulare Strömung entsteht und Pm ≤ 13 Pa.

3. Verfahren nach Anspruch 1, worin der Ausstoß durch die Öffnungen durch viskose Strömung oder Übergangsströmung entsteht und Pm > 13 Pa.

4. Verfahren nach Anspruch 1, worin der Behälter eine Abdeckung mit Öffnungen aufweist und eine Ablenkplatte zwischen der Abdeckung und dem Material umfasst, um zu verhindern, dass verdampftes Material durch die Öffnungen in die Abdeckung gelangt, ohne dass diese sich zuerst in Eingriff mit den Wandungen des Behälters befindet.

5. Verfahren nach Anspruch 1, worin $\frac{C_A}{C_B} \leq 0.1$ und über einem gewünschten Arbeitsbereich liegt.

6. Verfahren nach Anspruch 1, worin die Öffnungen von unterschiedlicher Größe und Form sind, oder worin unterschiedliche Abstände zwischen benachbarten Öffnungen bestehen, oder Kombinationen daraus, die ausgewählt sind, um einen im wesentlichen gleichförmigen Abfluss von verdampftem Material entlang der Längsrichtung des Behälters zu erzeugen.

7. Verfahren nach Anspruch 1, worin das Verfahren zur Herstellung eines OLED verwendbar ist.

8. Verfahren nach Anspruch 1, worin das im Behälter aufgenommene organische Feststoffmaterial dotiertes oder nicht dotiertes organisches Lochinjektionsmaterial, dotiertes oder nicht dotiertes organisches Lochtransportmaterial, dotiertes oder nicht dotiertes organisches Licht emittierendes Material oder dotiertes oder nicht dotiertes organisches Elektronentransportmaterial umfasst.

9. Verfahren nach Anspruch 1, mit dem Schritt: Einleiten eines inerten Gases in den Behälter zum Senken von $\frac{C_A}{C_B}$.

10. Verfahren nach Anspruch 9, worin das inerte Gas Argon oder Nitrogen ist.

11. Verfahren nach Anspruch 1, worin das Material ein phosphoreszierendes Material ist, ein elektrolumineszentes Material, das lichtelektrisch leitend ist oder lumineszierend durch die Wirkung ionisierender Strahlung.

**Revendications**

1. Procédé de revêtement d'un substrat de grande surface, comprenant les étapes consistant à :

   a) charger un matériau à déposer sur une pièce d'ouvrage dans un récipient allongé, le récipient présentant une conductance $C_B$ dans la direction de la longueur,
   b) chauffer le matériau dans le récipient pour faire vaporiser le matériau à une pression partielle Pm,
   c) le récipient définissant une ou plusieurs ouvertures selon un motif allongé dans la direction de la longueur afin d'émettre le matériau vaporisé par les ouvertures, les une ou plusieurs ouvertures présentant une conductance $C_A$, où $\frac{C_A}{C_B} \leq 0{,}5$, et

d) permettre un mouvement relatif du substrat et du récipient allongé dans une direction sensiblement perpendiculaire à la direction de la longueur.

2. Procédé selon la revendication 1, dans lequel l'émission au travers des ouvertures s'effectue par flux moléculaire et où $Pm \leq 13$ Pa.

3. Procédé selon la revendication 1, dans lequel l'émission au travers des ouvertures se fait par flux visqueux ou de transition et où $Pm > 13$ Pa.

4. Procédé selon la revendication 1, dans lequel le récipient comporte un couvercle présentant des ouvertures, et comprenant en outre un écran entre le couvercle et le matériau pour empêcher le matériau vaporisé de passer au travers des ouvertures dans le couvercle sans être préalablement en contact avec les parois du récipient.

5. Procédé selon la revendication 1, dans lequel $\frac{C_A}{C_B} \leq 0{,}1$ sur une plage souhaitée de fonctionnement.

6. Procédé selon la revendication 1, dans lequel les ouvertures présentent une taille, une forme ou un espacement divers entre des ouvertures adjacentes, ou des combinaisons de celles-ci, sélectionnés pour fournir un flux sortant sensiblement uniforme de matériau vaporisé selon la direction de la longueur du récipient.

7. Procédé selon la revendication 1, dans lequel le procédé est utilisé pour réaliser un dispositif OLED.

8. Procédé selon la revendication 1, dans lequel le matériau organique solide reçu dans le récipient comprend un matériau d'injection de trous organique dopé ou non dopé, un matériau de transport de trous organique dopé ou non dopé, un matériau émettant de la lumière organique dopé ou non dopé, ou un matériau transporteur d'électrons organique dopé ou non dopé.

9. Procédé selon la revendication 1, comprenant en outre l'étape consistant à introduire un gaz inerte dans le récipient pour diminuer le rapport $\frac{C_A}{C_B}$.

10. Procédé selon la revendication 9, dans lequel le gaz inerte est de l'argon ou de l'azote.

11. Procédé selon la revendication 1, dans lequel le matériau est un matériau phosphorescent, un matériau électroluminescent, photoconducteur, ou luminescent par l'action d'un rayonnement ionisant.

FIG. 1

FIG. 2

VACUUM

3

4

P

1

$R_a$

V

=

$R_a$ = APERTURE RESISTANCE

NET RESISTANCE TO GROUND = $R_B/N$

WHERE N = NUMBER OF APERTURES

=

$R_B$

$R_B$ = RESISTANCE OF BODY OF SOURCE

*FIG. 3*

*FIG. 4*

*FIG. 5*

FIG. 6

FIG. 7

FIG. 8

FIG. 9

FIG. 10

FIG. II

SOURCE SUBSTRATE SPACING
220

DEPOSITION RATE AT CENTER
222
224 — APERTURE AREA

CALCULATE SOURCE THROUGHPUT PER UNIT LENGTH REQUIRED FOR DESIRED RATE AND DESIRED THROW DISTANCE
200

224 — APERTURE AREA

226
APERTURE LENGTH

218
INPUT GUESS FOR VAPOR TEMPERATURE

228
MOLECULAR MASS OF MATERIAL

CALCULATE INTERNAL PRESSURE REQUIRED TO PRODUCE SPECIFIED THROUGHPUT
202

230
MOLECULAR DIAMETER

218
INPUT GUESS FOR VAPOR TEMPERATURE

CALCULATE MEAN FREE PATH OF VAPOR
204

232
APERTURE DIMENSIONS

234
SOURCE BODY DIMENSIONS

CALCULATE KNUDSEN NUMBER FOR APERTURES AND SOURCE BODY
206

232,234
GEOMETRICAL PARAMETERS

228,230
MATERIAL PARAMETERS (MOLECULAR MASS AND DIAMETER)

CALCULATE APERTURE AND SOURCE BODY CONDUCTANCES AND FORM LADDER NETWORK MODEL
208

CALCULATE PRESSURE DISTRIBUTION IN LADDER NETWORK
210

NO — TEMP. AGREES WITH PREVIOUS VALUE ?
216

YES

ESTIMATE VAPOR TEMPERATURE FROM VAPOR PRESSURE CURVE
212

FINAL OUTPUT FOR PRESSURE UNIFORMITY, AVERAGE PRESSURE, & VAPOR TEMPERATURE
214

FIG. 12